# EUROPÄISCHE PATENTSCHRIFT

(11) **EP 3 178 109 B1**
(45) Veröffentlichungstag und Bekanntmachung des Hinweises auf die Patenterteilung: **01.12.2021**
(21) Anmeldenummer: 16753705.9
(22) Anmeldetag: 02.08.2016
(51) Int. Cl.: H01L 21/687, C23C 16/458, H01L 21/673

(54) **SUBSTRATTRÄGER**
SUBSTRATE SUPPORT
SUPPORT DE SUBSTRAT

(30) Priorität: 24.08.2015 DE 102015113956
(43) Veröffentlichungstag der Anmeldung: 14.06.2017
(73) Patentinhaber: Meyer Burger (Germany) GmbH, 09337 Hohenstein-Ernstthal (DE)
(72) Erfinder: RASCHKE, Sebastian, 09380 Thalheim (DE); ANSORGE, Erik, 09127 Chemnitz (DE); KEHR, Mirko, 09439 Amtsberg (DE); BÖHM, Christian, 09337 Hohenstein-Ernstthal (DE)
(74) Vertreter: Steiniger, Carmen
(86) Internationale Anmeldenummer: PCT/IB2016/054630
(87) Internationale Veröffentlichungsnummer: WO 2017/033076

(56) Entgegenhaltungen:
- DE-A1-102009 021 563
- DE-A1-102014 100 024
- US-A1- 2007 026 148
- US-A1- 2010 089 314
- US-A1- 2015 228 529

## Beschreibung

Die vorliegende Erfindung betrifft einen Substratträger mit einer Substratträgerplatte, die eine vorderseitige Substratträgeroberfläche aufweist, auf der wenigstens ein Substrataufnahmebereich zur Aufnahme jeweils eines Substrates vorgesehen ist.

Substratträger, die bei der Bearbeitung von insbesondere Halbleitersubstraten, wie beispielsweise Siliziumwafern, zum Einsatz kommen, sollen wenigstens ein Substrat sicher halten und dessen bzw. deren einwandfreie Bearbeitung ermöglichen. Typischerweise kommen hierbei horizontal ausgerichtete Substratträger, sogenannte Trays oder Carrier, zum Einsatz, auf deren Oberfläche wenigstens ein flächiges Substrat, wie beispielsweise ein Halbleiterwafer, abgelegt und in dieser Stellung bearbeitet und/oder auf dem Substratträger transportiert wird. Das oder die Substrat(e) soll(en) dabei stabil auf dem Substratträger aufliegen. Nach erfolgter Bearbeitung bzw. nach erfolgtem Transport soll(en) das oder die Substrat(e) wieder schädigungsfrei von dem Substratträger genommen werden können.

Ein Substratträger der eingangs genannten Art ist beispielsweise aus der Druckschrift DE 40 26 244 C2 bekannt. Der bekannte Substratträger weist eine Substratträgerplatte mit einer Vertiefung auf, in der ein Substrat flächig aufliegt. Die Seitenwände der Vertiefung halten das Substrat in seiner Position. Für eine Vakuumfixierung des Substrates auf dem Substratträger sowie eine mögliche Belüftung nach einem Vakuumvorgang sind nach diesem Stand der Technik ein umlaufender Freiraum zwischen dem Substrat und dem Substratträger sowie eine unterhalb des Substrates angebrachte, durch den Substratträger hindurch reichende Bohrung vorgesehen. Das heißt, das Substrat liegt mittig auf einer Art Podest auf dem Substratträger auf, während die äußeren Bereiche des Substrates den Substratträger nicht berühren, da der Substratträger an diesen Bereichen vertieft ist. Außerdem kann sich mittig unter dem Substrat ein weiterer Freiraum befinden, wobei die Substratträgerplatte in diesem zentralen Bereich eine durchgehende Öffnung aufweist. Nachteilig an diesem Stand der Technik ist, dass sich das Podest insbesondere bei einem Plasmaprozess auf dem Substrat abbilden kann, wodurch die Eigenschaften des Substrates, beispielsweise die elektrische Leitfähigkeit, negativ beeinflusst werden können. Außerdem kann das Substrat in die umlaufende Vertiefung hinein kippen und liegt dann somit nicht mehr plan auf dem Substratträger auf. Dadurch können beispielsweise Beschädigungen des Substrates hervorgerufen werden und/oder Inhomogenitäten bei der Substratbearbeitung, wie beispielsweise eine inhomogene Substratbeschichtung, auftreten.

Die Druckschrift US 2007/0026148 A1 offenbart einen Substratträger, der aus einem flachen Ring mit voneinander beabstandeten ersten und zweiten Substratauflagestegen ausgebildet ist. Der Ring weist eine äußere, höhere Stufe und eine innere, niedrigere Stufe auf. Die ersten und die zweiten Substratauflagebereiche erstrecken sich strahlenförmig als erhabene Bereiche auf der inneren, niedrigeren Stufe. Während sich die Oberflächen der ersten Substratauflagebereiche auf dem gleichen Höhenniveau wie die Oberfläche der äußeren, höheren Stufe des Rings befinden, liegen die Oberflächen der zweiten Substratauflagebereiche zwar auf einem niedrigeren Höhenniveau als die äußere, höhere Stufe, aber auf einem höheren Höhenniveau als die innere, niedrigere Stufe des Rings.

In der Druckschrift DE 10 2009 021 563 A1 ist ein sich in einer Schleuse befindlicher Substratträger beschrieben. In den Substratträger sind Aussparungen eingebracht, in welchen jeweils ein Substrat liegt. Die Substrate werden durch einen auf deren Oberflächen gerichteten Gasstrom gegen den Substratträger gedrückt.

Aus der Druckschrift DE 10 2014 100 024 A1 geht ein Substratträger mit in einer Horizontalfläche angeordneten Lagerplätzen für jeweils ein kreisscheibenförmiges Substrat hervor, wobei sich zwischen den Lagerplätzen räumlich voneinander getrennte und Zentrierflanken aufweisende Sockel befinden, an welchen jeweils Anlagestellen zur berührenden Anlage eines Abschnittes des Randes eines Substrates ausgebildet sind.

US 2010/0089314A1 offenbart einen Substratträger mit einer Substratträgerplatte, die eine vorderseitige Substratträgeroberfläche aufweist, auf der ein Substrataufnahmebereich zur Aufnahme eines Substrates vorgesehen ist, wobei der Substrataufnahmebereich einen Innenbereich und einen um den Innenbereich verlaufenden Außenbereich aufweist, wobei der Außenbereich voneinander beabstandete, gegenüber einer Oberfläche des Innenbereichs erhabene Plateaus zur Auflage von Randbereichen des Substrates aufweist, wobei zwischen den Plateaus Belüftungskanäle vorgesehen sind. Die Belüftungskanäle liegen dabei als parallel zueinander ausgerichtete Rillen vor.

Es ist daher die Aufgabe der vorliegenden Erfindung, einen Substratträger vorzuschlagen, der möglichst ohne Beeinträchtigung der Eigenschaften des Substrates oder der Substratbearbeitung eine sichere Auflage des Substrates und bei einem schnellen Handling eine einfache, zerstörungsfreie Entnahme des Substrates von dem Substratträger gewährleistet.

Die Aufgabe wird erfindungsgemäß durch einen Substratträger mit einer Substratträgerplatte, die eine vorderseitige Substratträgeroberfläche aufweist, auf der wenigstens ein Substrataufnahmebereich zur Aufnahme jeweils eines Substrates vorgesehen ist, gelöst, wobei der Substrataufnahmebereich einen Innenbereich und einen um den Innenbereich verlaufenden Außenbereich aufweist, wobei der Außenbereich voneinander beabstandete, gegenüber einer Oberfläche des Innenbereichs erhabene Plateaus zur Auflage von Randbereichen des Substrates aufweist, wobei zwischen den Plateaus Belüftungskanäle vorgesehen sind, und wobei die Belüftungskanäle als parallel oder senkrecht zueinander ausgerichtete Rillen und die Plateaus als parallel oder senkrecht zueinander ausgerichtete Stege ausgebildet sind und sich die Belüftungskanäle auf dem gleichen Höhenniveau wie der Innenbereich befinden und diesen fluidisch mit einem über und um der/die Substratträgerplatte vorhandenen Raum verbinden.

Bei dem erfindungsgemäßen Substratträger sind in der vorderseitigen Substratträgeroberfläche mehrere, voneinander durch Unterbrechungen getrennte Auflageabschnitte vorgesehen, die sich zumindest teilweise unterhalb eines auf dem Substratträger vorgesehenen Substrates befinden und einen Auflagebereich für einen Randbereich eines auf den Substratträger abzulegenden Substrates ausbilden. Somit liegt das Substrat randseitig auf einem erhabenen Niveau gegenüber dem Innenbereich des Substrataufnahmebereiches auf der Substratträgerplatte auf. Zwischen den voneinander beabstandeten Plateaus sowie in dem Innenbereich des Substrataufnahmebereiches weist die vorderseitige Substratträgeroberfläche ein niedrigeres Niveau als auf den Plateaus auf. Dabei sind zwischen den Plateaus Kanäle ausgebildet, welche bei einer Be- und/oder Entlüftung als Belüftungskanäle wirken, also Gas in den Innenbereich des Substrataufnahmebereiches leiten können und somit eine Hinterlüftung des Substrates ermöglichen, was wiederum eine einfache, zerstörungsfreie Entnahme des Substrates von dem Substratträger ermöglicht.

Der erfindungsgemäße Substratträger bietet somit den Vorteil, dass das Substrat mit seinen Randbereichen auf dem Substrataufnahmebereich zügig planparallel ablegbar ist und sich dabei kein Gaspolster zwischen dem Substrat und den Auflageabschnitten ausbilden kann, wodurch ein horizontales Verrutschen des Substrates auf dem Substratträger weitgehend vermieden wird. Dabei befindet sich in dem Innenbereich des Substrataufnahmebereiches wenigstens ein Freiraum zwischen dem Substratträger und dem Substrat. Das in diesem Freiraum befindliche Gas kann über die zwischen den Plateaus befindlichen Belüftungskanäle bei der Substratauflage nach außen hin entweichen, sodass das Substrat nicht auf dem Außenbereich "aufschwimmt". Dies erleichtert die sichere und zügige Ablage des Substrates auf der Substratträgerplatte, da ein Verrutschen des Substrates auf einem Gaspolster vermieden wird.

Die Belüftungskanäle bewirken zudem bei einer Entnahme des Substrates von dem Substratträger, dass seitlich Gas unter das Substrat geführt wird und dadurch das Substrat leicht und zerstörungsfrei von der Substratträgerplatte abgehoben werden kann. Weiterhin sind die Plateaus und Belüftungskanäle nur in einem Randbereich des Substrates vorgesehen, sodass eine Abbildung dieser Strukturen auf dem Substrat möglichst gering gehalten wird.

In einer bevorzugten Ausführungsform des erfindungsgemäßen Substratträgers sind die Plateaus auf einem gleichen Niveau wie die vorderseitige Substratträgeroberfläche, ausgenommen einer Oberfläche des oder der Innenbereiche(s), ausgebildet. Das heißt, lediglich für den Innenbereich und die Belüftungskanäle ist ein anderes, nämlich niedrigeres, Niveau als für die übrige vorderseitige Substratträgeroberfläche vorgesehen. Die Plateaus können dadurch ausgebildet werden, dass sie Bereiche der vorderseitigen Substratträgeroberfläche zwischen den Belüftungskanälen darstellen. Dadurch ergibt sich eine günstige Fertigung des erfindungsgemäßen Substratträgers.

In einer vorteilhaften Weiterbildung des erfindungsgemäßen Substratträgers sind die Belüftungskanäle allseitig um den Substrataufnahmebereich vorgesehen. Dadurch wird eine gleichmäßige Ent- und Belüftung einer Rückseite des Substrates ermöglicht. Das Luft- oder Gaspolster unter dem Substrat wird also bei der Substratträgerauflage gleichmäßig entfernt bzw. bei der Substratentnahme gleichmäßig wieder hergestellt, sodass das Substrat nicht nur sicher und plan auf dem Substratträger aufliegen, sondern auch sicher und schnell wieder von diesem entnommen werden kann.

Besonders bevorzugt sind die Plateaus bei der vorliegenden Erfindung stegartig ausgebildet. Damit ergibt sich einerseits eine stabile Auflagemöglichkeit während andererseits die stegartigen Plateaus nur eine geringe Auflagefläche bilden und sich damit nur minimal bis gar nicht auf einer Rückseite des Substrates und/oder auf der Substatträgervorderseite bei der Substratbehandlung abbilden. Die Auflageabschnitte bildenden Plateaus sind also vorzugsweise länglich und/oder rechteckig geformt, wodurch eine einfache und preisgünstige Herstellung der Plateaus und/oder der Belüftungskanäle ermöglicht wird.

Gemäß einer bevorzugten Ausführungsform des erfindungsgemäßen Substratträgers sind die Belüftungskanäle in die vorderseitige Substratträgeroberfläche eingefräst. Dadurch sind die Belüftungskanäle insbesondere einfach und kostengünstig fertigbar. Ebenso kann der Innenbereich, welcher gegenüber dem Außenbereich ein niedrigeres Höhenniveau aufweist, in die vorderseitige Substratträgeroberfläche eingefräst sein.

In einer alternativen Ausführungsform der vorliegenden Erfindung ist in dem Innenbereich wenigstens eine Stützstruktur vorgesehen, auf der das Substrat zumindest teilweise aufliegen kann. Dadurch wird die Berührungsfläche zwischen dem Substrat und dem Substratträger effektiv erhöht, wodurch die Wärmeübertragung zwischen dem Substratträger und dem Substrat verbessert wird. Durch die Stützstruktur kann es jedoch zur Abbildung von deren Struktur auf dem Substrat, insbesondere auch auf einer Substratvorderseite, sowie in einem Plasmaprozess zu unerwünschten Beeinflussungen des Plasmas kommen.

In einer geeigneten Ausführungsform des erfindungsgemäßen Substratträgers sind die Plateaus und/oder die Stützstruktur durch einen Materialauftrag auf die vorderseitige Substratträgeroberfläche aufgebracht. Möglichkeiten zum Aufbringen solcher plateauartiger Auflageabschnitte sowie der Stützstruktur sind beispielsweise 3D-Druck, (photo)lithographische Verfahren, Anschrauben, Verlöten, Anpunkten oder Schweißen. Außerdem können die Ausführungsformen der vorliegenden Erfindung, bei welchen Belüftungskanäle in die vorderseitige Substratträgeroberfläche eingefräst und die Plateaus durch Materialauftrag auf die vorderseitige Substratträgeroberfläche aufgebracht werden, auch miteinander kombiniert werden.

In einer besonders vorteilhaften Weiterbildung des erfindungsgemäßen Substratträgers liegt eine Höhe der Plateaus und/oder eine Tiefe der Belüftungskanäle in einem Bereich von 0,1 mm bis 1 mm, bevorzugt in einem Bereich von 0,2 mm bis 0,5 mm. Mit der Höhe der Plateaus ist hierbei die Höhe gegenüber dem Innenbereich des Substratauflagebereiches und/oder die Höhe gegenüber einer tiefsten Stelle eines Belüftungskanals gemeint. Es hat sich herausgestellt, dass die Be- und Entlüftung in einem Tiefen- und/oder Höhenbereich von 0,1 mm bis 1 mm, bevorzugt von 0,2 mm bis 0,5 mm, für ein schnelles Handling des wenigstens einen Substrates zufriedenstellend verläuft. Andererseits soll zwischen dem Substrat und dem Substratträger eine gute thermische Anbindung vorliegen, was durch den Tiefen- und/oder Höhenbereich von 0,1 mm bis 1 mm, bevorzugt von 0,2 mm bis 0,5 mm, ebenfalls gewährleistet ist.

Als besonders vorteilhaft hat sich bei einem erfindungsgemäßen Substratträger erwiesen, wenn ein Abstand der Plateaus zueinander und/oder eine Breite der Belüftungskanäle in einem Bereich von 0,1 mm bis 5 mm, bevorzugt in einem Bereich von 0,2 mm bis 1 mm, liegt. Mit dem Abstand der Plateaus zueinander ist hierbei der Abstand gemeint, welchen ein Plateau in dem Außenbereich des Substratauflagebereiches zu einem benachbarten Plateau aufweist, also der Abstand, welcher durch die Breite eines Belüftungskanals zwischen zwei Plateaus hervorgerufen wird. In diesem Abstands- und/oder Breitenbereich von 0,1 mm bis 5 mm, bevorzugt von 0,2 mm bis 1 mm, hat sich ein zufriedenstellender Gasfluss bei einem Ent- und/oder Belüftungsvorgang herausgestellt.

In einer bevorzugten Ausführungsform des erfindungsgemäßen Substratträgers ist die Substratträgerplatte aus wenigstens einem elektrisch leitfähigen Material ausgebildet und/oder mit wenigstens einem elektrisch leitfähigen Material beschichtet. Dadurch kann die Substratträgerplatte in einer Substratbehandlungskammer beispielsweise als eine Elektrode ausgeführt werden. Dies ist insbesondere nützlich, wenn das wenigstens eine zu behandelnde Substrat auf ein bestimmtes elektrisches Potenzial eingestellt werden soll. Als elektrisch leitfähiges Material kommt beispielsweise ein Metall oder eine Legierung in Betracht, insbesondere Aluminium, Titan oder auch eine Legierung eines dieser Metalle. Weiterhin weisen elektrisch leitfähige Materialien auch eine gute Wärmeleitfähigkeit auf, was für die Substratträgerplatte eine gewünschte Eigenschaft darstellt, um so beispielsweise mit einer an einer Rückseite der Substratträgerplatte angeordneten Temperiervorrichtung das auf der vorderseitigen Substratträgeroberfläche der Substratträgerplatte angeordnete Substrat zu wärmen oder zu kühlen.

Nach einer vorteilhaften Weiterbildung des erfindungsgemäßen Substratträgers beträgt der Außenbereich des Substrataufnahmebereiches höchstens ein Zehntel einer Oberfläche eines auf dem Substratträger vorgesehenen Substrates. Dadurch wird eine mögliche Beeinflussung des Substrates durch eine geometrische Abbildung des Außenbereiches auf dem Substrat in einem Bearbeitungsprozess möglichst gering gehalten.

Besonders bevorzugt ist wenigstens eine aus der vorderseitigen Substratträgeroberfläche aufragende Auskragung zur seitlichen Begrenzung einer Substratauflagefläche auf dem Substrataufnahmebereich vorgesehen. Die Auskragung dient als seitlicher Halt für das Substrat. Damit kann das Substrat also nicht horizontal verrutschen, beispielsweise im belüfteten Zustand, und ist in seiner Position auf dem Substrataufnahmebereich festgelegt. Vorteilhafterweise sind um einen Substrataufnahmebereich mehrere Auskragungen vorgesehen, sodass das Verrutschen eines Substrates in alle Richtungen unterbunden wird. Außerdem kann zwischen benachbarten Substraten jeweils genau eine Auskragung vorgesehen sein, sodass sich benachbarte Substrate jeweils eine Auskragung "teilen". Es können zwischen benachbarten Substraten alternativ aber auch voneinander beabstandete Auskragungen vorgesehen sein, sodass jede Auskragung jeweils nur einem Substrat benachbart ist.

In einer alternativen Ausführungsform der vorliegenden Erfindung kann die Auskragung als wenigstens eine um den Substrataufnahmebereich verlaufende Stufe in der vorderseitigen Substratträgeroberfläche ausgebildet sein. Diese Stufe weist ein höheres Niveau auf als die Plateaus des Außenbereiches, wodurch ein sogenanntes Substratnest gebildet wird. Durch die Stufe verlaufen Belüftungskanäle, welche beispielsweise mit den Belüftungskanälen des Außenbereichs verbunden sein können. Somit wird das Substrat nicht vollumfänglich von der Stufe dicht anliegend umgeben und es kann eine effektive Be- und Entlüftung des Substrataufnahmebereiches gewährleistet werden.

In einer vorteilhaften Weiterbildung des erfindungsgemäßen Substratträgers ist die wenigstens eine Auskragung ein Stift. Mit Stift ist hierbei ein zylindrischer Körper gemeint, dessen Mantelfläche sich senkrecht zu der vorderseitigen Substratträgeroberfläche erstreckt. Eine geläufige Bezeichnung für einen solchen Stift ist "Pin". Derartige zylindrische Körper sind insbesondere günstig herstellbar. In alternativen Ausführungsformen kann der Stift auch als vielseitiges Prisma ausgebildet sein, beispielsweise als dreiseitiges Prisma, Quader oder ein achtseitiges Prisma, wobei sich jeweils eine Mantelfläche des Prismas entlang einer länglichen Erstreckung des Prismas senkrecht zu der vorderseitigen Substratträgeroberfläche erstreckt.

Vorzugsweise ist die Auskragung in eine in die vorderseitige Substratträgeroberfläche eingebrachte Sacklochbohrung eingesetzt. Eine Sacklochbohrung stellt eine Ausnehmung in der Substratträgeroberfläche dar, welche die Substratträgerplatte nicht durchgreift. Die Auskragung wird in die Sacklochbohrung eingesteckt, also versinkt sie zu einem Teil in der Bohrung und lediglich ein Teil der Auskragung kragt aus der Bohrung heraus, um das Substrat an einem seitlichen Verrutschen zu hindern. Die Auskragung steckt also lose in der Sacklochbohrung. Alternativ kann die Auskragung auch formschlüssig in der Sacklochbohrung gehalten werden, beispielsweise durch einen Bajonettverschluss oder gegeneinander keilartig verlaufende Oberflächen der Sacklochbohrung und der Auskragung. Dadurch kann die Auskragung fest, aber lösbar, mit der Substratträgerplatte verbunden sein. In einem Spezialfall kann die Auskragung als Schraube und die Sacklochbohrung mit einem Gewinde versehen ausgebildet sein, sodass die Auskragung in die vorderseitige Substratträgeroberfläche einschraubbar ausgebildet ist.

In einer besonderen Ausgestaltung der vorliegenden Erfindung ist die Auskragung von einer Rückseite des Substratträgers eingebracht, wobei die Auskragung aus einer Öffnung der vorderseitigen Substratträgeroberfläche herausragt, wobei die Auskragung in der Öffnung durch die Größe der Öffnung gehalten wird und wobei die Auskragung mit einem Fixierelement von der Rückseite in der Öffnung fixiert ist. In dieser Variante ist also eine durch die Substratträgerplatte hindurchgehende Öffnung vorgesehen, durch welche die Auskragung von der Rückseite des Substratträgers hindurch reichen kann. Die Öffnung und die Auskragung können dabei so ausgeformt sein, dass in Richtung der vorderseitigen Substratträgeroberfläche eine Art Anschlag besteht, die Auskragung also nur bis zu einem bestimmten Punkt durch die Öffnung hindurch reichen kann. An der Rückseite des Substratträgers und somit an der Rückseite der Öffnung ist die Auskragung an dem Substratträger durch das Fixierelement befestigt. Die Befestigung kann insbesondere gasdicht gestaltet sein, sodass die Fixierung der Auskragung die Öffnung im Substratträger abdichtet.

Gemäß einer weiteren Alternative der vorliegenden Erfindung ist die Auskragung in einer in der Substratträgerplatte parallel zur vorderseitigen Substratträgeroberfläche verlaufenden Nut angeordnet, wobei ein in der Nut befindliches Halteelement der Auskragung von einem Gegenhalteelement der Nut umgriffen wird. Die Nut kann also in einem tiefen Bereich breiter ausgeführt sein als in einem Bereich nahe der vorderseitigen Substratträgeroberfläche, sodass eine Verjüngung der Nut in Richtung der vorderseitigen Substratträgeroberfläche vorliegt. Der verjüngte Bereich kann das Gegenhalteelement ausbilden. Die Auskragung kann ihrerseits an einem untersten, in der Nut vorgesehenen Bereich verbreitert sein, ähnlich einem Schraubenkopf. Dieser verbreiterte Bereich der Auskragung kann das Halteelement ausbilden. Dadurch wird die Auskragung durch Formschluss in der Nut gehalten. Im Falle einer länglichen Nut kann die Auskragung, wie ein so genannter Nutenstein, in eine gewünschte Position verschoben werden und ein- oder beidseitig durch wenigstens ein Stoppelement in der gewünschten Position gegen ein Verrutschen gesichert werden.

In einer bevorzugten Ausführungsform des erfindungsgemäßen Substratträgers ist die Auskragung aus wenigstens einem elektrischen Isolator ausgebildet. Elektrische Isolatoren sind schlechte Wärmeleiter, wodurch die Ausbildung einer Wärmesenke durch den Stift als Auskragung vermieden wird. Außerdem kann die Substratträgerplatte in einem Substratbehandlungsprozess als Elektrode verwendet werden. Durch die Ausführung der Auskragung als elektrischer Isolator wird vermieden, dass sich Potenzialspitzen über der Substratträgerplatte aufbauen. Wird das Substrat beispielsweise in einem Plasma behandelt, wird also eine Verzerrung des Plasmas vermieden, indem die Auskragung als elektrischer Isolator ausgebildet ist. Als Material für die Auskragung kommt beispielsweise Glas, Quarz, Keramik oder Kunststoff in Betracht, insbesondere Aluminiumoxid. Daher können solche Auskragungen auch als "Keramik-Pins" bezeichnet werden.

Gemäß einer vorteilhaften Weiterbildung des erfindungsgemäßen Substratträgers ist die Auskragung innen hohl ausgebildet. Die Auskragung kann also beispielsweise ein Hohlzylinder sein. Dies ist günstig für einen Substratbehandlungsprozess im Vakuum, da die Auskragung beim Entlüften so nicht aus der Sacklochbohrung durch den entstehenden Unterdruck herausgezogen werden kann.

Als vorteilhaft hat sich außerdem herausgestellt, wenn die Auskragung an einem von der Substratträgerplatte weg zeigenden Ende spitz oder verrundet zulaufend ausgebildet ist. Sollte also ein Substrat auf der vorderseitigen Substratträgeroberfläche fehlerhafterweise außerhalb des Substrataufnahmebereiches abgelegt werden, sodass das Substrat eine geneigte Oberfläche der Auskragung berührt, führt diese geneigte Oberfläche der Auskragung zu einer Richtungsweisung des Substrates hin zum Substrataufnahmebereich. Dadurch wird also bewirkt, dass die Substrate zwischen den Auskragungen angeordnet werden.

Vorteilhafte Ausführungsformen der vorliegenden Erfindung, deren Aufbau, Funktion und Vorteile sind im Folgenden anhand von Figuren näher erläutert, wobei
- Figur 1: schematisch eine Draufsicht auf eine vorderseitige Substratträgeroberfläche eines erfindungsgemäßen Substratträgers zeigt;
- Figur 2: schematisch eine Draufsicht auf die vorderseitige Substratträgeroberfläche des Substratträgers aus Figur 1 mit auf Substrataufnahmebereichen des Substratträgers abgelegten Substraten zeigt;
- Figur 3: schematisch eine Querschnittansicht eines erfindungsgemäßen Substratträgers mit darauf abgelegten Substraten entlang von Plateaus von Substrataufnahmebereichen des Substratträgers zeigt;
- Figur 4: schematisch eine weitere Querschnittsansicht des erfindungsgemäßen Substratträgers aus Figur 3 mit darauf abgelegten Substraten entlang von Belüftungskanälen zeigt;
- Figur 5: eine Detailansicht eines erfindungsgemäßen Substratträgers mit einer zylinder- oder quaderförmigen Auskragung in einer Sacklochbohrung in einer Querschnittsdarstellung zeigt;
- Figur 6: eine Detailansicht eines erfindungsgemäßen Substratträgers mit einer pyramiden- oder kegelförmigen Auskragung in einer Sacklochbohrung in einer Querschnittsdarstellung zeigt;
- Figur 7: eine Detailansicht eines erfindungsgemäßen Substratträgers mit einer innen hohl ausgebildeten Auskragung in einer Sacklochbohrung in einer Querschnittsdarstellung zeigt;
- Figur 8: eine Detailansicht einer alternativen Ausführungsform eines erfindungsgemäßen Substratträgers mit einer durch eine Öffnung des Substratträgers hindurch reichenden Auskragung in einer Querschnittsdarstellung zeigt;
- Figur 9: eine Detailansicht einer weiteren alternativen Ausführungsform eines erfindungsgemäßen Substratträgers mit einer in einer Nut gehaltenen Auskragung in einer Querschnittsdarstellung zeigt; und
- Figur 10: schematisch eine Draufsicht auf einen Substrataufnahmebereich eines erfindungsgemäßen Substratträgers mit in dem Innenbereich angeordneten Stützstrukturen zeigt.

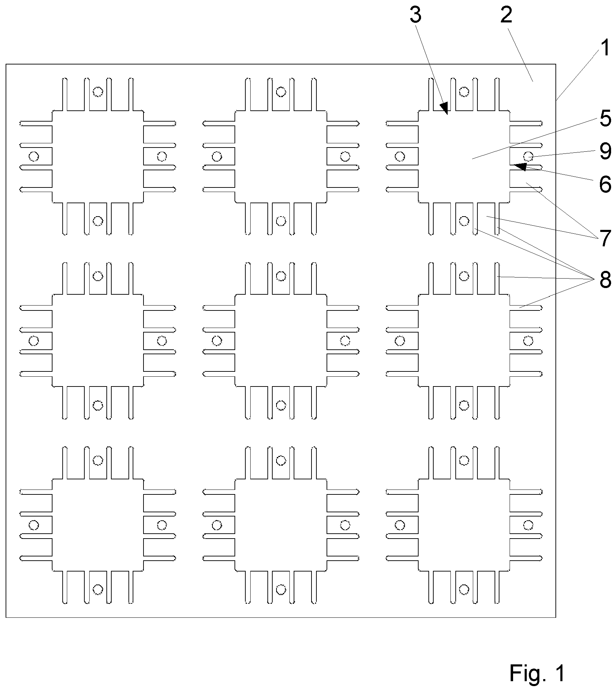

Figur 1 zeigt eine Ausführungsform eines erfindungsgemäßen Substratträgers in einer Draufsicht. Der Substratträger weist eine Substratträgerplatte 1 mit einer vorderseitigen Substratträgeroberfläche 2 auf. Auf der Substratträgeroberfläche 2 sind in mehreren Spalten und Reihen rechteckige Substrataufnahmebereiche 3 voneinander beabstandet angeordnet. Jeder Substrataufnahmebereich 3 weist jeweils einen rechteckigen Innenbereich 5 mit einem niedrigen Höhenniveau sowie einen um den Innenbereich 5 verlaufenden Außenbereich 6 auf. Alternativ ist auch vorstellbar, dass der Substrataufnahmebereich 3 und der Innenbereich 5 andere Geometrien als rechteckig aufweisen, beispielsweise kreisförmig, oval oder achteckig.

In dem Außenbereich 6 sind Plateaus 7 mit einem gegenüber dem Innenbereich 5 erhöhten Höhenniveau sowie Belüftungskanäle 8 mit dem niedrigen Höhenniveau des Innenbereiches 5 vorgesehen. In der Ausführungsform in Figur 1 sind die Belüftungskanäle 8 als parallel oder senkrecht zueinander ausgerichtete Rillen und die Plateaus 7 als parallel oder senkrecht zueinander ausgerichtete Stege ausgebildet. In anderen Ausführungsformen der vorliegenden Erfindung können die Belüftungskanäle 8 auch zueinander in einem spitzen oder stumpfen Winkel angeordnet sein. Ebenso können die Plateaus 7 zueinander spitze oder stumpfe Winkel bilden.

Um den Substrataufnahmebereich 3 sind aus der Substratträgeroberfläche 2 heraus ragende Auskragungen 9 vorgesehen. In der Ausführungsform in Figur 1 ist je Seite des Substrataufnahmebereiches 3 genau eine Auskragung 9 vorgesehen, sodass der rechteckige Substrataufnahmebereich 3 von vier Auskragungen 9 umgeben ist. Dadurch kann ein Verrutschen eines Substrates 4 in jeder Richtung unterbunden werden. In alternativen Ausführungsformen können je Seite des Substrataufnahmebereiches 3 mehrere Auskragungen 9 angeordnet sein. Bei kreisförmigen oder ovalen Geometrien des Substrataufnahmebereiches 3 ist es vorteilhaft, die Auskragungen 9 ebenfalls kreisförmig oder oval um den Substrataufnahmebereich 3 anzuordnen. Die Auskragungen 9 sind in der Ausführungsform von Figur 1 auf Plateaus 7 angeordnet. Alternativ können die Auskragungen 9 in Belüftungskanälen 8 angeordnet sein, wobei die Belüftungskanäle 8 dann breiter ausgebildet sind als die Auskragungen 9, damit ein Gasfluss durch die Belüftungskanäle 8 nicht behindert wird.

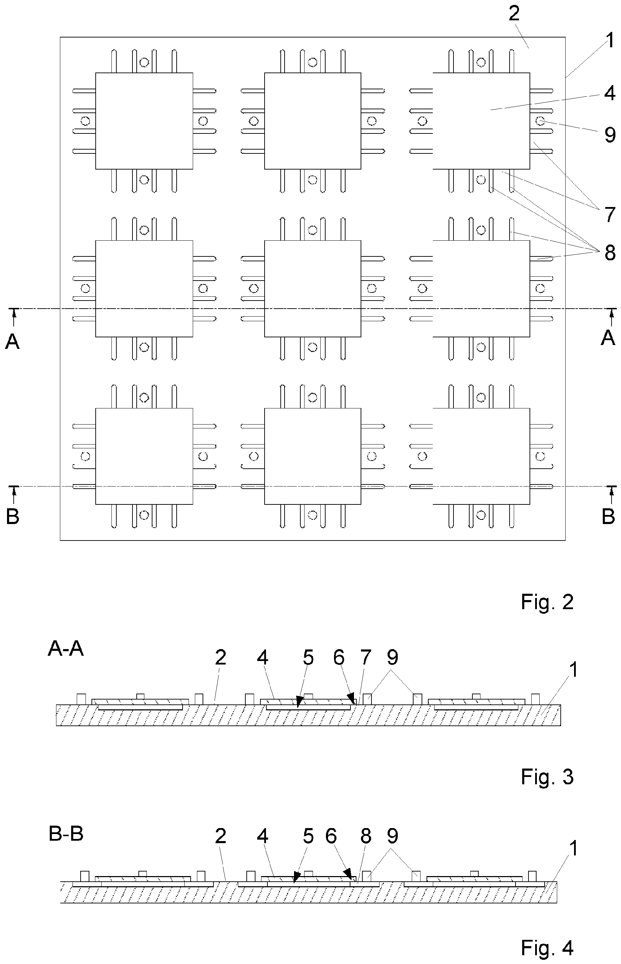

Figur 2 zeigt den Substratträger aus Figur 1 in einer Draufsicht auf die vorderseitige Substratträgeroberfläche 2 mit auf der Substratträgerplatte 1 aufliegenden Substraten 4. Die Substrate 4 liegen hier auf den Substrataufnahmebereichen 3 auf und verdecken diese. Die Substrate 4 sind in der hier gezeigten Ausführungsform rechteckig ausgebildet, können alternativ aber beispielsweise auch runde oder andere, beispielsweise vieleckige Geometrien aufweisen.

Seitlich beabstandet zu den Substraten 4 sind die Auskragungen 9 angeordnet. Zwischen den Substraten 4 und den Auskragungen 9 ist ein geringer Abstand vorgesehen, sodass je ein Substrat 4 zwischen vier das Substrat 4 umgebenden Auskragungen 9 angeordnet werden kann. Andererseits ist dieser Abstand zwischen dem Substrat 4 und den Auskragungen 9 so gering gewählt, dass das Substrat 4 im Falle einer geringen horizontalen Verschiebung von einer der Auskragungen 9 begrenzt wird.

Weiterhin sind seitlich und in einem Randbereich der Substrate 4 die Belüftungskanäle 8 angeordnet, welche jeweils von einem Außenbereich 6 in einen Innenbereich 5 verlaufen und somit teilweise unter dem jeweiligen Substrat 4 angeordnet sind. Zwischen zwei Belüftungskanälen 8 ist jeweils ein Plateau 7 angeordnet, wobei das Substrat 4 auf den Plateaus 7 aufliegt, wobei die Plateaus 7 in Figur 2 lediglich als Bereiche zwischen den Belüftungskanälen 8 erkennbar sind.

In Figur 3 ist ein Querschnitt eines erfindungsgemäßen Substratträgers mit darauf aufliegenden Substraten 4 gemäß der Linie A-A aus Figur 2 gezeigt, also entlang der Plateaus 7. Auf der vorderseitigen Substratträgeroberfläche 2 der Substratträgerplatte 1 liegen die Substrate 4 auf. Seitlich beabstandet zu den Substraten 4 sind jeweils mehrere Auskragungen 9 mit geringem Abstand zu dem jeweiligen Substrat 4 angeordnet. Das Substrat 4 liegt jeweils in einem Außenbereich 6 auf wenigstens einem Plateau 7 auf, wohingegen in dem unter dem Substrat 4 angeordneten Innenbereich 5 ein Frei- oder Hohlraum zwischen dem Substrat 4 und der Substratträgerplatte 1 vorliegt.

In Figur 4 ist ein Querschnitt eines erfindungsgemäßen Substratträgers mit darauf aufliegenden Substraten 4 gemäß der Linie B-B aus Figur 2 gezeigt, also entlang der Belüftungskanäle 8. Im Unterschied zu Figur 3 ist hierbei im Außenbereich 6 der unter dem Substrat 4 verlaufende Belüftungskanal 8 zu sehen. Der Belüftungskanal 8 befindet sich auf dem gleichen Höhenniveau wie der Innenbereich 5 und verbindet diesen fluidisch mit einem über und um der Substratträgerplatte 1 vorhandenen Raum. Wird also für einen Vakuumprozess eine Substratträgerplatte 1 mit darauf abgelegten Substraten 4 entlüftet, kann das in dem in dem Innenbereich 5 angeordneten, zwischen der Substratträgerplatte 1 und dem Substrat 4 ausgebildeten Hohlraum befindliche Gas durch die Belüftungskanäle 8 nach außen geleitet werden. Im Falle einer Belüftung nach einem Vakuumprozess kann wiederum das Gas durch die Belüftungskanäle 8 in den Innenbereich 5 strömen und somit das Substrat 4 hinterlüften.

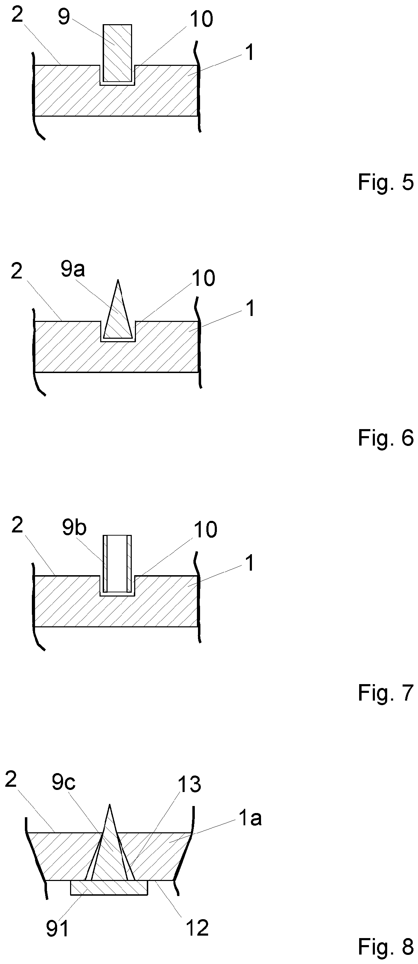

In Figur 5 ist schematisch im Querschnitt eine Detailansicht einer als Stift ausgeführten Auskragung 9 eines erfindungsgemäßen Substratträgers in einer Sacklochbohrung 10 gezeigt. Die Sacklochbohrung 10 ist in die vorderseitige Substratträgeroberfläche 2 der Substratträgerplatte 1 eingebracht, wobei die Sacklochbohrung 10 eine Vertiefung in der vorderseitigen Substratträgeroberfläche 2 darstellt, welche nicht durch die Substratträgerplatte 1 hindurchgeht. Die Sacklochbohrung 10 kann als eine runde Ausnehmung ausgebildet sein, also in Form eines Zylinders, alternativ kann sie jedoch auch eine eckige oder ovale Grundfläche aufweisen.

Die Auskragung 9 ist in ihrer Grundfläche vorzugsweise der Grundfläche der Sacklochbohrung 10 kongruent, jedoch kleiner ausgebildet, sodass ein reibungsloses Einsetzen der Auskragung 9 in die Sacklochbohrung 10 ermöglicht ist. Im Falle einer runden Sacklochbohrung 10 ist die stiftförmige Auskragung 9 also als Zylinder ausgebildet. In der Ausführungsform nach Figur 5 ist die Auskragung 9 aus einem Block und als gerader Körper ausgeführt.

In Figur 6 ist schematisch im Querschnitt eine Detailansicht einer anstelle der Auskragung 9 in einer Ausführungsform des erfindungsgemäßen Substratträgers verwendbare Auskragung 9a gezeigt. Die Auskragung 9a ist als nach oben hin spitz zulaufender Körper ausgebildet, also im Falle einer runden Grundfläche als Kegel und im Falle einer eckigen Grundfläche als Pyramide. Alternativ ist auch vorstellbar, dass ein in der Sacklochbohrung 10 versenkter Sockel der Auskragung 9a als gerader Körper ausgebildet ist und nur ein über die Sacklochbohrung erhabener Bereich der Auskragung 9a als spitz zulaufender Körper ausgeformt ist. In der Ausführungsform von Figur 6 ist die Auskragung 9a aus einem Block ausgebildet.

In Figur 7 ist schematisch im Querschnitt eine Detailansicht einer weiteren alternativen Ausführungsform einer anstelle der Auskragung 9 oder 9a bei dem erfindungsgemäßen Substratträger einsetzbaren Auskragung 9b gezeigt. Die Auskragung 9b ist innen hohl ausgebildet, kann also ein Zylinderrohr oder ein innen hohles Prisma sein. Dies hat insbesondere in einem Vakuumprozess den Vorteil, dass bei einer Entlüftung die Auskragung 9b aufgrund des über der vorderseitigen Substratträgeroberfläche 2 entstehenden Unterdrucks nicht aus der Sacklochbohrung 10 hinausgezogen wird.

In Figur 8 ist schematisch im Querschnitt eine alternative Ausführungsform eines erfindungsgemäßen Substratträgers gezeigt, in dem die Substratträgerplatte 1a eine durchgehende Öffnung 13 aufweist. Eine Auskragung 9c reicht von einer Rückseite 12 des Substratträgers bis zur vorderseitigen Substratträgeroberfläche 2 durch die Öffnung 13 hindurch. Sowohl die Öffnung 13 als auch die Auskragung 9c sind sich in Richtung der vorderseitigen Substratträgeroberfläche 2 hin verjüngend ausgebildet, wobei die Öffnung 13 und die Auskragung 9c in der gezeigten Ausführungsform an der vorderseitigen Substratträgeroberfläche 2 den gleichen Umfang aufweisen, an dieser Stelle also ein Anschlag vorliegt, wodurch die Auskragung 9c nicht weiter durch die Öffnung 13 hindurch ragen kann. An der Rückseite 12 des Substratträgers ist an der Auskragung 9c ein Fixierelement 91 angeordnet, welches beispielsweise durch Löten fest und gasdicht mit der Rückseite 12 verbunden sein kann. Dadurch wird ein Herausfallen der Auskragung 9c aus der Substratträgerplatte 1a verhindert.

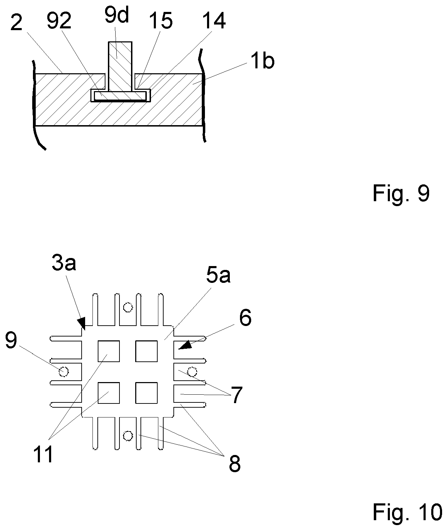

In Figur 9 ist schematisch im Querschnitt eine weitere alternative Ausführungsform eines erfindungsgemäßen Substratträgers mit der Substratträgerplatte 1b gezeigt. Die Substratträgerplatte 1b weist in der vorderseitigen Substratträgeroberfläche 2 eine Nut 14 auf, welche in einem versenkten Bereich verbreitert ist gegenüber einem der Substratträgeroberfläche 2 nahen Bereich. Die in der Nut 14 angeordnete Auskragung 9d ist formangepasst an die Nut 14 ausgebildet, weist also in einem unteren Bereich eine Verbreiterung auf, welche das Halteelement 92 ausbildet. Das Halteelement 92 wird von dem Gegenhaltelement 15 umgriffen, welches durch die Nut 14 in der Substratträgerplatte 1b ausgebildet wird. Dadurch wird ein vertikales Herausziehen der Auskragung 9d aus der Nut 14 durch Formschluss verhindert. Gegen ein horizontales Verrutschen in der Nut 14 kann die Auskragung 9d durch wenigstens ein Stoppelement gesichert sein, welches jeweils neben der Auskragung 9d in der Nut 14 fixiert werden kann.

In Figur 10 ist eine alternative Ausführungsform eines Aufnahmebereiches 3a in einer Draufsicht gezeigt. Im Gegensatz zu der Ausführungsform gemäß Figur 1 sind im Innenbereich 5a vier jeweils rechteckig geformte Stützstrukturen 11 angeordnet, welche das gleiche Niveau ausbilden können wie die Plateaus 7. Somit können die Stützstrukturen 11 mit einem Substrat 4, welches auf dem Substrataufnahmebereich 3a abgelegt werden kann, in Berührung kommen. Dadurch wird einerseits ein Durchbiegen des Substrates 4 über dem Innenbereich 3a vermieden. Außerdem wird so eine Berührungsfläche zwischen dem Substrat 4 und der Substratträgerplatte 1 im Vergleich zu der Ausführungsform gemäß Figur 1 vergrößert, wodurch die Wärmeübertragung zwischen der Substratträgerplatte 1 und dem Substrat 4 vergrößert wird.

## Patentansprüche

1. Substratträger mit einer Substratträgerplatte (1, 1a, 1b), die eine vorderseitige Substratträgeroberfläche (2) aufweist, auf der wenigstens ein Substrataufnahmebereich (3, 3a) zur Aufnahme jeweils eines Substrates (4) vorgesehen ist, wobei der Substrataufnahmebereich (3, 3a) einen Innenbereich (5) und einen um den Innenbereich (5) verlaufenden Außenbereich (6) aufweist, wobei der Außenbereich (6) voneinander beabstandete, gegenüber einer Oberfläche des Innenbereichs (5) erhabene Plateaus (7) zur Auflage von Randbereichen des Substrates (4) aufweist, wobei zwischen den Plateaus (7) Belüftungskanäle (8) vorgesehen sind, **dadurch gekennzeichnet, dass** die Belüftungskanäle (8) als parallel oder senkrecht zueinander ausgerichtete Rillen und die Plateaus (7) als parallel oder senkrecht zueinander ausgerichtete Stege ausgebildet sind und sich die Belüftungskanäle (8) auf dem gleichen Höhenniveau wie der Innenbereich (5) befinden und diesen fluidisch mit einem über und um der/die Substratträgerplatte (1, 1a, 1b) vorhandenen Raum verbinden.

2. Substratträger nach Anspruch 1, **dadurch gekennzeichnet, dass** die Plateaus (7) auf einem gleichen Niveau wie die vorderseitige Substratträgeroberfläche (2), ausgenommen einer Oberfläche des oder der Innenbereiche(s) (5), ausgebildet sind.

3. Substratträger nach Anspruch 1 oder 2, **dadurch gekennzeichnet, dass** die Belüftungskanäle (8) allseitig um den Substrataufnahmebereich (3a) vorgesehen sind.

4. Substratträger nach wenigstens einem der vorhergehenden Ansprüche, **dadurch gekennzeichnet, dass** die Belüftungskanäle (8) in die vorderseitige Substratträgeroberfläche (2) eingefräst sind.

5. Substratträger nach wenigstens einem der vorhergehenden Ansprüche, **dadurch gekennzeichnet, dass** in dem Innenbereich (5) wenigstens eine Stützstruktur (11) vorgesehen ist, auf der das Substrat (4) zumindest teilweise aufliegen kann.

6. Substratträger nach wenigstens einem der vorhergehenden Ansprüche, **dadurch gekennzeichnet, dass** die Plateaus (7) durch einen Materialauftrag auf die vorderseitige Substratträgeroberfläche (2) aufgebracht sind.

7. Substratträger nach wenigstens einem der vorhergehenden Ansprüche, **dadurch gekennzeichnet, dass** die Substratträgerplatte (1, 1a, 1b) aus wenigstens einem elektrisch leitfähigem Material ausgebildet und/oder mit wenigstens einem elektrisch leitfähigen Material beschichtet ist.

8. Substratträger nach wenigstens einem der vorhergehenden Ansprüche, **dadurch gekennzeichnet, dass** wenigstens eine aus der vorderseitigen Substratträgeroberfläche (2) aufragende Auskragung (9, 9a, 9b, 9c, 9d) zur seitlichen Begrenzung einer Substratauflagefläche auf dem Substrataufnahmebereich (3) vorgesehen ist.

9. Substratträger nach Anspruch 8, **dadurch gekennzeichnet, dass** die wenigstens eine Auskragung (9, 9a, 9b, 9c, 9d) ein Stift ist.

10. Substratträger nach Anspruch 8 oder 9, **dadurch gekennzeichnet, dass** die Auskragung (9, 9a, 9b, 9c, 9d) in eine in die vorderseitige Substratträgeroberfläche (2) eingebrachte Sacklochbohrung (10) eingesetzt ist.

11. Substratträger nach Anspruch 8 oder 9, **dadurch gekennzeichnet, dass** die Auskragung (9, 9a, 9b, 9c, 9d) von einer Rückseite (12) des Substratträgers eingebracht ist, wobei die Auskragung (9, 9a, 9b, 9c, 9d) aus einer Öffnung (13) der vorderseitigen Substratträgeroberfläche (2) herausragt, wobei die Auskragung (9, 9a, 9b, 9c, 9d) in der Öffnung (13) durch die Größe der Öffnung (13) gehalten wird und wobei die Auskragung (9, 9a, 9b, 9c, 9d) mit einem Fixierelement (91) von der Rückseite (12) in der Öffnung (13) fixiert ist.

12. Substratträger nach Anspruch 8 oder 9, **dadurch gekennzeichnet, dass** die Auskragung (9, 9a, 9b, 9c, 9d) in einer in der Substratträgerplatte (1) parallel zur vorderseitigen Substratträgeroberfläche (2) verlaufenden Nut (14) angeordnet ist, wobei ein in der Nut (14) befindliches Halteelement (92) der Auskragung (9, 9a, 9b, 9c, 9d) von einem Gegenhalteelement (15) der Nut (14) umgriffen wird.

13. Substratträger nach wenigstens einem der Ansprüche 8 bis 12, **dadurch gekennzeichnet, dass** die Auskragung (9, 9a, 9b, 9c, 9d) aus wenigstens einem elektrischen Isolator ausgebildet ist.

14. Substratträger nach wenigstens einem der Ansprüche 8 bis 13, **dadurch gekennzeichnet, dass** die Auskragung (9, 9a, 9b, 9c, 9d) innen hohl ausgebildet ist.

15. Substratträger nach wenigstens einem der Ansprüche 8 bis 14, **dadurch gekennzeichnet, dass** die Auskragung (9, 9a, 9b, 9c, 9d) an einem von der Substratträgerplatte (1) weg zeigenden Ende spitz oder verrundet zulaufend ausgebildet ist.

## Claims

1. Substrate carrier with a substrate carrier plate (1, 1a, 1b) comprising a front-sided substrate carrier surface (2), on which at least one substrate receiving area (3, 3a) for receiving a substrate (4), respectively, is provided, wherein
the substrate receiving area (3, 3a) comprises an interior area (5) and exterior area (6) extending around the interior area (5), wherein the exterior area (6) comprises spaced plateaus (7) being raised compared to a surface of the interior area (5) for the support of edge areas of the substrate (4), wherein ventilation channels (8) are provided bet-ween the plateaus (7),
**characterized in that**
the ventilation channels (8) are provided as grooves being parallel or vertically aligned to each other and the plateaus (7) are provided as bars being parallel or vertically aligned to each other and the ventilation channels (8) are on the same height level as the interior area (5) and are connecting same fluidically with a space provided above and around the substrate carrier plate (1, 1a, 1b).

2. Substrate carrier according to claim 1, **characterized in that** the plateaus (7) are provided on a same level as the front-sided substrate carrier surface (2), except for a surface of the interior area(s) (5).

3. Substrate carrier according to claim 1 or 2, **characterized in that** the ventilation channels (8) are provided circumferentially around the substrate receiving area (3a).

4. Substrate carrier according to at least one of the preceding claims, **characterized in that** the ventilation channels (8) are milled into the front-sided substrate carrier surface (2).

5. Substrate carrier according to at least one of the preceding claims, **characterized in that** in the interior area (5), at least one support structure (11) is provided, on which the substrate (4) can at least partly be supported.

6. Substrate carrier according to at least one of the preceding claims, **characterized in that** the plateaus (7) are applied by a material coating on the front-sided substrate carrier surface (2).

7. Substrate carrier according to at least one of the preceding claims, **characterized in that** the substrate carrier plate (1, 1a, 1b) is provided of at least one electrically conductive material and/or is coated with at least one electrically conductive material.

8. Substrate carrier according to at least one of the preceding claims, **characterized in that** at least one projection (9, 9a, 9b, 9c, 9d) projecting from the front-sided substrate carrier surface (2) is provided for a lateral limitation of a substrate support area on the substrate receiving area (3).

9. Substrate carrier according to claim 8, **characterized in that** the at least one projection (9, 9a, 9b, 9c, 9d) is a stud.

10. Substrate carrier according to claim 8 or 9, **characterized in that** the projection (9, 9a, 9b, 9c, 9d) is inserted into a blind hole (10) provided in the front-sided substrate carrier surface (2).

11. Substrate carrier according to claim 8 or 9, **characterized in that** the projection (9, 9a, 9b, 9c, 9d) is inserted from a back side (12) of the substrate carrier, wherein the projection (9, 9b, 9c, 9d) projects from an opening (13) of the front-sided substrate carrier surface (2), wherein the projection (9, 9a, 9b, 9c, 9d) is held by the size of the opening (13) and wherein the projection (9, 9a, 9b, 9c, 9d) is fixed from the back side (12) in the opening (13) by a fixation element (91).

12. Substrate carrier according to claim 8 or 9, **characterized in that** the projection (9, 9a, 9b, 9c, 9d) is arranged in a groove (14) of the substrate carrier plate (1) running parallel to the front-sided substrate carrier surface (2), wherein a holding element (92) of the projection (9, 9a, 9b, 9c, 9d) provided in the groove (14) is encompassed by a counter holding element (15) of the groove (14).

13. Substrate carrier according to at least one of the claims 8 to 12, **characterized in that** the projection (9, 9a, 9b, 9c, 9d) is provided of at least one electrical insulator.

14. Substrate carrier according to at least one of the claims 8 to 13, **characterized in that** the projection (9, 9a, 9b, 9c, 9d) is hollow inside.

15. Substrate carrier according to at least one of the claims 8 to 14, **characterized in that** the projection (9, 9a, 9b, 9c, 9d) is tapering pointed or rounded at one end facing away from the substrate carrier plate (1).

## Revendications

1. Support de substrat comportant une plaque de support de substrat (1, 1a, 1b), qui présente une surface de support de substrat (2) sur laquelle au moins une zone de réception de substrat (3, 3a), destinée à recevoir un substrat (4) respectivement, est prévue,
la zone de réception de substrat (3, 3a) présentant une zone intérieure (5) et une zone extérieure (6) s'étendant autour de la zone intérieure (5), la zone extérieure (6) présentant des plateaux (7) espacés les uns des autres et surélevés par rapport à une surface de la zone intérieure (5), lesquels permettent de supporter des régions de bord du substrat (4), des canaux de ventilation (8) étant prévus entre les plateaux (7),
**caractérisé en ce que** les canaux de ventilation (8) sont conçus comme des rainures alignées parallèlement ou perpendiculairement les unes aux autres et les plateaux (7) sont conçus comme des nervures alignées parallèlement ou perpendiculairement les unes aux autres, et les canaux de ventilation (8) sont au même niveau de hauteur que la zone intérieure (5) et la relient fluidiquement à un espace existant au-dessus et autour de la plaque de support de substrat (1, 1a, 1b).

2. Support de substrat selon la revendication 1, **caractérisé en ce que** les plateaux (7) sont conçus au même niveau que le côté avant de la surface de support de substrat (2), à l'exception d'une surface de la ou des zones intérieures (5).

3. Support de substrat selon la revendication 1 ou 2, **caractérisé en ce que** les canaux de ventilation (8) sont prévus sur tous les côtés autour de la zone de réception de substrat (3a).

4. Support de substrat selon au moins l'une des revendications précédentes, **caractérisé en ce que** les canaux de ventilation (8) sont fraisés dans le côté avant de la surface de support de substrat (2).

5. Support de substrat selon au moins l'une des revendications précédentes, **caractérisé en ce qu'**au moins une structure d'appui (11), sur laquelle le substrat (4) peut reposer au moins partiellement, est prévue dans la zone intérieure (5).

6. Support de substrat selon au moins l'une des revendications précédentes, **caractérisé en ce que** les plateaux (7) sont apposés sur le côté avant de la surface de support de substrat (2) par application de matériau.

7. Support de substrat selon au moins l'une des revendications précédentes, **caractérisé en ce que** la plaque de support de substrat (1, 1a, 1b) est formée à partir d'au moins un matériau électriquement conducteur et/ou est revêtue d'au moins un matériau électriquement conducteur.

8. Support de substrat selon au moins l'une des revendications précédentes, **caractérisé en ce qu'**au moins une saillie (9, 9a, 9b, 9c, 9d) dépassant du côté avant de la surface de support de substrat (2) est prévue et destinée à la délimitation latérale d'une surface de support de substrat sur la zone de réception de substrat (3).

9. Support de substrat selon la revendication 8, **caractérisé en ce que** l'au moins une saillie (9, 9a, 9b, 9c, 9d) est une broche.

10. Support de substrat selon la revendication 8 ou 9, **caractérisé en ce que** la saillie (9, 9a, 9b, 9c, 9d) est insérée dans un trou borgne (10) appliqué dans le côté avant de la surface de support de substrat (2).

11. Support de substrat selon la revendication 8 ou 9, **caractérisé en ce que** la saillie (9, 9a, 9b, 9c, 9d) est introduite depuis un côté arrière (12) du support de substrat, la saillie (9, 9a, 9b, 9c, 9d) faisant saillie depuis une ouverture (13) du côté avant de la surface de support de substrat (2), la saillie (9, 9a, 9b, 9c, 9d) étant maintenue dans l'ouverture (13) par la taille de l'ouverture (13) et la saillie (9, 9a, 9b, 9c, 9d) étant fixée dans l'ouverture (13) avec un élément de fixation (91) depuis le côté arrière (12).

12. Support de substrat selon la revendication 8 ou 9, **caractérisé en ce que** la saillie (9, 9a, 9b, 9c, 9d) est disposée dans une rainure (14) s'étendant dans la plaque de support de substrat (1) parallèlement au côté avant de la surface de support de substrat (2), un élément de maintien (92) de la saillie (9, 9a, 9b, 9c, 9d) situé dans la rainure (14) étant entouré par un élément de contre-maintien (15) de la rainure (14).

13. Support de substrat selon au moins l'une des revendications 8 à 12, **caractérisé en ce que** la saillie (9, 9a, 9b, 9c, 9d) est formée par au moins un isolateur électrique.

14. Support de substrat selon au moins l'une des revendications 8 à 13, **caractérisé en ce que** la saillie (9, 9a, 9b, 9c, 9d) est conçue comme creuse à l'intérieur.

15. Support de substrat selon au moins l'une des revendications 8 à 14, **caractérisé en ce que** la saillie (9, 9a, 9b, 9c, 9d) est conçue comme pointue ou arrondie à une extrémité orientée à l'opposé de la plaque de support de substrat (1).
